# EUROPEAN PATENT APPLICATION

(11) **EP 2 518 523 A1**
(43) Date of publication of application: **31.10.2012**
(21) Application number: 11164124.7
(22) Date of filing: 28.04.2011
(51) Int. Cl.: G01R 33/48

(54) **MRI PRFS thermometry with susceptibility correction**

(71) Applicant: Koninklijke Philips Electronics N.V., 5621 BA Eindhoven (NL)
(72) Inventor: Baron, Paul, 5600 AE Eindhoven (NL); Sprinkhuizen, Sara, 5600 AE Eindhoven (NL); Deckers, Roel, 5600 AE Eindhoven (NL); Bakker, Chris, J., G., 5600 AE Eindhoven (NL); Bartels, Wilbert, 5600 AE Eindhoven (NL)
(74) Representative: Damen, Daniel Martijn

(57) **Abstract**

A medical apparatus (300, 400, 500, 600) comprising a magnetic resonance imaging system and a memory (322) containing processor (326) instructions. The instructions cause the processor to acquire (100, 200) fat locating magnetic resonance data (352), acquire (102, 202) preliminary Proton Resonant Frequency Shift (PRFS) data (342) and preliminary fat temperature data (344), and generate (104, 204) fat location data (354). The instructions cause the processor to repeatedly: acquire (106, 208) PRFS data (348) and fat temperature data (350), calculate (108, 210) a fat temperature change map (366), calculate (110, 212) a magnetic susceptibility change map (356) using the fat temperature change map and the fat location data, calculate (112, 214) a magnetic field disturbance map (358) using the magnetic susceptibility change map, and calculate (114, 216) a temperature map (360) using the PRFS data, the preliminary PRFS data, and the magnetic field disturbance map, thereby correcting for temperature errors caused by temperature-induced susceptibility changes of fat tissue.

## Description

### TECHNICAL FIELD

The invention relates to magnetic resonance thermometry, in particular for correcting errors in proton resonance frequency shift measurements due to temperature induced changes of the magnetic susceptibility of fatty tissue.

### BACKGROUND OF THE INVENTION

Magnetic resonance thermometry may be used to determine either the absolute temperature of a volume or a change in temperature, depending upon the technique used. For determining the absolute temperature several magnetic resonance peaks are typically measured. Methods which measure changes in temperature are typically faster and have been used to take temperature measurements for guiding thermal treatments. For example Proton resonance frequency shift based MR thermometry may be employed to provide temperature maps in water inside the tissue during the ablation procedure for real-time feedback control of the heating process. However, heat induced magnetic susceptibility changes of fat may give rise to local field disturbances leading to significant temperature errors inside the tumor. The proton resonance frequency shift method requires an accurate knowledge of the magnetic field strength. Changes in magnetic susceptibility in fatty tissue may cause distortions of the magnetic field sufficient to cause errors in the temperature measurements.

On page 16 of the Doctoral thesis of Sara Maria Sprinkhuizen "MR Thermometry for guidance of thermal therapy," Utrecht University (the Netherlands), 2010, ISBN: 978-90-393-5405-6 it is noted that in composite tissues, those which contain both both water and fat, the resonance frequency of water protons is also affected by heating-induced changes of the susceptibility of fat.

### SUMMARY OF THE INVENTION

The invention provides for a medical apparatus, a computer program product, and a method in the independent claims. Embodiments are given in the dependent claims.

Embodiments of the invention may solve this and other problems by using T1-based MR Thermometry of fat to calculate the susceptibility changes so as to correct for the errors due to the related field disturbances.

The Proton Resonance Frequency (PRF) temperature dependence in fat is almost completely due to susceptibility change. The impact of this, however, in thermal therapy has been largely ignored. In fatty organs, like the breast, heat induced susceptibility changes of fat give rise to local field disturbances leading to significant errors in temperature measured by PRF-shift based thermometry inside the tumor. The referenceless MR thermometry methods may be used as a general technique for correcting field disturbances and may be applicable here. However, the technique requires a suitable border around the heating area for phase interpolation. Embodiments of the invention may address this problem by using an alternative correction method correction method: Measuring the temperature change of fat to correct for field disturbances caused by the heating of fat in regions containing water where PRFS is used. The change in temperature of fat can be measured using T1-based thermometry. From the change in temperature the change in susceptibility can be calculated. The resulting change in field disturbance can be calculated fast for any arbitrary susceptibility distribution using the discrete Fourier transform.

Embodiments of the invention may employ T1- based MR Thermometry of fat to calculate the susceptibility changes so as to correct for the PRFS thermometry errors due to the related field disturbances. The calculation of the field disturbance via the Discrete Fourier transform method has the advantage of being fast, and may be used real-time. Because the Discrete Fourier transform method can be applied to any arbitrary susceptibility, the correction method would work with any heating pattern or tissue water/fat distribution.

One embodiment of a method may be:
1. Measure the change in temperature of fat using T1-based thermometry. (Alternatively use T2 or PD or sequences with a T1 or T2 weighting). For water/fat separation use Water Suppression or IDEAL pulse sequences.
2. From step 1 make a fat mask, ie. by thresholding T1-weighted images.
3. For every voxel of the mask calculate the change in susceptibility due to the temperature change of fat.
4. Calculate the field disturbance due to the heating of fat using the numeric Fourier transform method.
5. Correct the PRFS thermometry maps in water using the field disturbance from step 4.

For step 3, a possible improvement would be to also determine the change in susceptibility of the non-fatty component of voxels containing fat. It would be assumed to have the same change in temperature as the fat. The total susceptibility change would be calculated from both contributions.

A 'computer-readable storage medium' as used herein encompasses any tangible storage medium which may store instructions which are executable by a processor of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the processor of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the processor. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example a data may be retrieved over a modem, over the internet, or over a local area network.

'Computer memory' or 'memory' is an example of a computer-readable storage medium. Computer memory is any memory which is directly accessible to a processor. Examples of computer memory include, but are not limited to: RAM memory, registers, and register files.

'Computer storage' or 'storage' is an example of a computer-readable storage medium. Computer storage is any non-volatile computer-readable storage medium. Examples of computer storage include, but are not limited to: a hard disk drive, a USB thumb drive, a floppy drive, a smart card, a DVD, a CD-ROM, and a solid state hard drive. In some embodiments computer storage may also be computer memory or vice versa.

A 'processor' as used herein encompasses an electronic component which is able to execute a program or machine executable instruction. References to the computing device comprising "a processor" should be interpreted as possibly containing more than one processor or processing core. The processor may for instance be a multi-core processor. A processor may also refer to a collection of processors within a single computer system or distributed amongst multiple computer systems. The term computing device should also be interpreted to possibly refer to a collection or network of computing devices each comprising a processor or processors. Many programs have their instructions performed by multiple processors that may be within the same computing device or which may even be distributed across multiple computing devices.

A 'user interface' as used herein is an interface which allows a user or operator to interact with a computer or computer system. A 'user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, gear sticks, steering wheel, pedals, wired glove, dance pad, remote control, and accelerometer are all examples of user interface components which enable the receiving of information or data from an operator.

A 'hardware interface' as used herein encompasses an interface which enables the processor of a computer system to interact with and/or control an external computing device and/or apparatus. A hardware interface may allow a processor to send control signals or instructions to an external computing device and/or apparatus. A hardware interface may also enable a processor to exchange data with an external computing device and/or apparatus. Examples of a hardware interface include, but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or 'display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen, Cathode ray tube (CRT), Storage tube, Bistable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

Magnetic Resonance (MR) data is defined herein as being the recorded measurements of radio frequency signals emitted by atomic spins by the antenna of a Magnetic resonance apparatus during a magnetic resonance imaging scan. A Magnetic Resonance Imaging (MRI) image is defined herein as being the reconstructed two or three dimensional visualization of anatomic data contained within the magnetic resonance imaging data. This visualization can be performed using a computer.

Magnetic resonance data may comprise the measurements of radio frequency signals emitted by atomic spins by the antenna of a Magnetic resonance apparatus during a magnetic resonance imaging scan which contains information which may be used for magnetic resonance thermometry. Magnetic resonance thermometry functions by measuring changes in temperature sensitive parameters. Examples of parameters that may be measured during magnetic resonance thermometry are: the proton resonance frequency shift, the diffusion coefficient, or changes in the T1 and/or T2 relaxation time may be used to measure the temperature using magnetic resonance. The proton resonance frequency shift is temperature dependent, because the magnetic field that individual protons, hydrogen atoms, experience depends upon the surrounding molecular structure. An increase in temperature decreases molecular screening due to the temperature affecting the hydrogen bonds. This leads to a temperature dependence of the proton resonant frequency.

The proton density depends linearly on the equilibrium magnetization. It is therefore possible to determine temperature changes using proton density weighted images.

The relaxation times T1, T2, and T2-star (sometimes written as T2*) are also temperature dependent. The reconstruction of T1, T2, and T2-star weighted images can therefore be used to construct thermal or temperature maps.

The temperature also affects the Brownian motion of molecules in an aqueous solution. Therefore pulse sequences which are able to measure diffusion coefficients such as a pulsed diffusion gradient spin echo may be used to measure temperature.

One of the most useful methods of measuring temperature using magnetic resonance is by measuring the proton resonance frequency (PRF) shift of water protons. The resonant frequency of the protons is temperature dependent. As the temperature changes in a voxel the frequency shift will cause the measured phase of the water protons to change. The temperature change between two phase images can therefore be determined. This method of determining temperature has the advantage that it is relatively fast in comparison to the other methods. The PRF method is discussed in greater detail than other methods herein. However, the methods and techniques discussed herein are also applicable to the other methods of performing thermometry with magnetic resonance imaging.

An 'ultrasound window' as used herein encompasses a window which is able to transmit ultrasonic waves or energy. Typically a thin film or membrane is used as an ultrasound window. The ultrasound window may for example be made of a thin membrane of BoPET (Biaxially-oriented polyethylene terephthalate).

In one aspect the invention provides for a medical apparatus comprising a magnetic resonance imaging system for acquiring magnetic resonance data from a subject. The medical apparatus further comprises a processor for controlling the medical apparatus. For instance the processor may send and receive signals and control commands to the magnetic resonance imaging system instructing it to acquire the magnetic resonance data. The medical apparatus further comprises a memory containing machine-readable instructions for execution by the processor. Execution of the instructions causes the processor to acquire fat locating magnetic resonance data using the magnetic resonance imaging system. As used herein fat locating magnetic resonance data encompasses magnetic resonance data which may be used for determining the location of fat within the subject. For instance the fat locating magnetic resonance data may be acquired using a pulse sequence which incorporates a water suppression technique. For instance the spectral suppression or the PROSET technique based upon binomial excitation pulses may be used. A fat selected by a conventional excitation pulse sequence may also be used.

Execution of the instructions further causes the processor to acquire preliminary magnetic resonance thermometry data using the magnetic resonance imaging system. The preliminary magnetic resonance thermometry data comprises preliminary proton resonant frequency shift magnetic resonance data and preliminary fat temperature magnetic resonance data. Proton resonant frequency shift magnetic resonance data as used herein encompasses magnetic resonance data which may be used to determine a relative temperature change using the proton resonant frequency shift method. Fat temperature change magnetic resonance data as used herein encompasses magnetic resonance data which may be used to determine the temperature or relative temperature change of fat. In some embodiments fat temperature magnetic resonance data and proton resonant frequency shift magnetic resonance data are acquired simultaneously. In other embodiments these two types of magnetic resonance data are acquired sequentially using different pulse sequences. In some embodiments the fat temperature magnetic resonance data and the preliminary proton resonant frequency shift may be acquired using a hybrid pulse sequence. For instance if the fat temperature magnetic resonance data is for measuring the relative temperature change of fat using a change in the T1 relaxation time then a pulse sequence can be constructed which uses the change in the phase for detecting the change in temperature using the proton resonant frequency shift method and the flip angles in a pulse sequence can be varied to determine the temperature change in a fat using the T1 relaxation time.

Execution of the instructions further causes the processor to generate fat location data using the fat locating magnetic resonance data. The fat location data is descriptive of the spatial distribution of fat within the subject. The fat location data may take several different forms. For instance a fat mask may be constructed. The fat mask identifies voxels which have a percentage of fat which exceeds a predetermined threshold. Such a fat mask may be used to identify voxels which are entirely filled with fat or are substantially filled with fat. In yet other embodiments the fraction of fat in each voxel may be identified. For instance the Dixon technique may be used to determine the fat fraction in the voxels. During execution of the previous processor instructions, the location of fat within the subject has been determined and preliminary magnetic resonance thermometry data has been acquired. In the following steps more magnetic resonance thermometry data is acquired repeatedly in order to repeatedly calculate a temperature map.

Execution of the instructions further causes the processor to repeatedly acquire magnetic resonance thermometry data using the magnetic resonance imaging system. The magnetic resonance thermometry data comprises proton resonant frequency shift magnetic resonance data and fat temperature magnetic resonance data. Execution of the instructions further cause the processor to repeatedly calculate a spatially dependent fat temperature change using the preliminary fat temperature magnetic resonance data and the fat temperature magnetic resonance data. Execution of the instructions further cause the processor to repeatedly calculate a magnetic susceptibility change map using the fat temperature change map and the fat location data. The magnetic susceptibility of fat changes with temperature.

By calculating a spatially dependent fat temperature change map and using knowledge of the location of fat within the subject a magnetic susceptibility change map is able to be calculated. Execution of the instructions further causes the processor to repeatedly calculate a magnetic field disturbance map using the magnetic susceptibility change map. For small changes in the magnetic susceptibility it is possible to calculate and/or approximate the magnetic field disturbance that may be caused by the change in susceptibility of the fat. Execution of the instructions further causes the processor to repeatedly calculate a temperature map using the proton resonant frequency shift magnetic resonance data, the preliminary proton resonant frequency shift magnetic resonance data, and the magnetic field disturbance map. The proton resonant frequency shift method is able to accurately calculate a change in temperature however this method is directly proportional to the magnetic field. This embodiment may be beneficial because it provides for a means of correcting for changes in the magnetic field due to temperature change of fat. This may provide for more accurate temperature measurements and may enable better guidance and control of thermal treatment systems such as high-intensity focused ultrasound system using magnetic resonance imaging.

In another embodiment the medical apparatus further comprises a thermal treatment system for treating a target zone of a subject. A thermal treatment system as used herein encompasses a system or apparatus which is able to raise or lower the temperature of the target zone in a controlled fashion. Execution of the instructions further causes the processor to treat the target zone at least partially during acquisition of the magnetic resonance thermometry data. This embodiment may be beneficial because the improved method of calculating a temperature map can be used to guide the thermal treatment system while it is treating the target zone.

In another embodiment execution of the instructions further causes the processor to generate temperature treatment system control commands in accordance with the temperature map. For instance the treatment of the target zone may be performed using a treatment plan which instructs the treatment system to heat a particular volume or volumes of the subject or cool those volumes to a specified temperature for a predetermined period of time. The system may be able to use the measurement to determine if the thermal treatment system is indeed raising or lowering the temperature of the target zone as specified in the treatment plan.

In another embodiment the temperature treatment system is a high-intensity focused ultrasound system.

In another embodiment the temperature treatment system is a radio-frequency tissue heating system. For instance a radio-frequency antenna may be used to heat the target volume using radio-frequency energy. Typically an additional antenna is used or placed in the vicinity of the subj ect to generate the radio-frequency energy that heats the target zone.

In another embodiment the treatment system is a microwave applicator. A microwave applicator is adapted for directing microwave energy at the target zone. This may cause an increase in temperature of the target zone.

In another embodiment the temperature treatment system is any one of the following a cryo-ablator. A cryo-ablator is adapted for cooling the target zone or a portion of the target zone to temperatures which cause the ablation of tissue.

In another embodiment the temperature treatment system is a laser. The laser may be used to selectively ablate tissue.

In another embodiment the magnetic field disturbance map is calculated numerically using a Fourier transform method. In this technique a disturbance to the B0 or main field of the magnet is assumed to be a linear addition. The map of the local magnetic susceptibility or the Δchi map can then be used using Fourier techniques to calculate a ΔB0 map. This ΔB0 map has a spatial dependence and may then be used to correct the temperature map.

In another embodiment the fat temperature magnetic resonance data is acquired using a fat selective pulse sequence. In some embodiments the fat selective pulse sequence is used for acquiring data which indicates the temperature change of the fat that is yet not affected by the magnetic susceptibility.

In another embodiment the fat temperature magnetic resonance data comprises fat T1 relaxation time data.

In another embodiment the fat temperature magnetic resonance data comprises fat T2 relaxation time data, fat T2-* relaxation time data, or proton density data. These three quantities have a low sensitivity to magnetic field disturbance caused by changes in magnetic susceptibility due to temperature change.

In another embodiment the fat temperature magnetic resonance data comprises fat T1 relaxation time data. The fat selective pulse sequence comprises at least one fat selective binomial radio-frequency excitation pulse. This embodiment is particularly advantageous because it may be used to acquire T1 relaxation time data from fat tissue selectively.

In another embodiment the fat location data is a fat mask. The fat mask identifies voxels with fat content above a predetermined threshold. This embodiment is beneficial because it provides a means of separating tissue types into predominantly fat or into tissue which does not contain fat above a predetermined threshold.

In another embodiment the fat location is descriptive of a fat content of individual voxels. For instance the fat location data may indicate a fraction of the voxels filled with fat. This embodiment is advantageous because it may be used to create an accurate estimate of the change in the magnetic susceptibility of various voxels. This may lead to a more accurate calculation of a temperature map.

In another embodiment the magnetic resonance thermometry data and/or the preliminary magnetic resonance thermometry data is acquired using interleaving pulse sequences to sequentially acquire the proton resonant frequency shift magnetic resonance data and the fat temperature magnetic resonance data. This embodiment is advantageous because different techniques may be used to acquire the fat temperature magnetic resonance data and the proton resonant frequency shift magnetic resonance data.

In another embodiment the magnetic resonance thermometry data and/or the preliminary magnetic resonance thermometry data is acquired simultaneously by using a hybrid pulse sequence which acquires the proton resonant frequency shift magnetic resonance data and the fat temperature magnetic resonance data simultaneously. This embodiment is advantageous because the two types of magnetic resonance data may be acquired more rapidly. This leads to more rapid updating of the temperature map and may be used for guidance of a thermal treatment system.

In another embodiment the fat location magnetic resonance data is magnetic resonance data acquired using a Dixon technique. This is advantageous because the Dixon technique may be used to determine the fraction of a voxel filled with fat or fat tissue.

In another embodiment the temperature map is corrected using the magnetic field disturbance map. This embodiment is particularly advantageous because the proton resonant frequency shift method is susceptible to changes in the B0 or main magnetic field of the magnet. Correcting using the magnetic field disturbance map corrects the temperature measurements to account for magnetic susceptibility changes in the fat tissue.

In another aspect the invention provides for a computer program product comprising machine-executable instructions for execution by a processor of a medical apparatus comprising a magnetic resonance imaging system for acquiring magnetic resonance data from a subject. The computer program product may for instance be stored on a computer-readable storage medium. Execution of the instructions causes the processor to acquire fat locating magnetic resonance data using the magnetic resonance imaging system. Execution of the instructions further causes the processor to acquire preliminary magnetic resonance thermometry data using the magnetic resonance imaging system. The preliminary magnetic resonance thermometry data comprises preliminary proton resonant frequency shift magnetic resonance data and preliminary fat temperature magnetic resonance data. Execution of the instructions further causes the processor to generate fat location data using the fat locating magnetic resonance data. The fat location data is descriptive of the spatial distribution of fat within the subject. Execution of the instructions causes the processor to repeatedly acquire magnetic resonance thermometry data using the magnetic resonance imaging system. The magnetic resonance thermometry data comprises proton resonant frequency shift magnetic resonance data and fat temperature magnetic resonance data. Execution of the instructions further causes the processor to repeatedly calculate a spatially dependent fat temperature change map using the preliminary fat temperature magnetic resonance data and the fat temperature magnetic resonance data. Execution of the instructions further cause the processor to repeatedly calculate the magnetic susceptibility change map using the fat temperature change map and the fat location data. Execution of the instructions further causes the processor to repeatedly calculate a magnetic field disturbance map using the magnetic susceptibility change map. Execution of the instructions further causes the processor to repeatedly calculate a temperature map using the proton resonant frequency shift magnetic resonance data, preliminary proton resonant frequency shift magnetic resonance data, and the magnetic field disturbance map. Benefits of this embodiment have been previously discussed.

In another aspect the invention provides for a method of calculating a temperature map using a magnetic resonance imaging system. The magnetic resonance imaging system is adapted for acquiring magnetic resonance data from a subject. The method may also be implemented as a computer-implemented method. The method comprises the step of causing the processor to acquire fat locating magnetic resonance data using the magnetic resonance imaging system. The method further comprises the step of causing the processor to acquire preliminary magnetic resonance thermometry data using the magnetic resonance imaging system. The preliminary magnetic resonance thermometry data comprises preliminary proton resonant frequency shift magnetic resonance data and preliminary fat temperature magnetic resonance data. The method further comprises the step of generating fat location data using the fat locating magnetic resonance data. The fat location data is descriptive of the spatial distribution of fat within the subject.

The method further comprises the step of repeatedly acquiring magnetic resonance thermometry data using the magnetic resonance imaging system. The magnetic resonance thermometry data comprises proton resonant frequency shift magnetic resonance data and fat temperature magnetic resonance data. The method further comprises the step of calculating a spatially dependent fat temperature change map using the preliminary fat temperature magnetic resonance data and the fat temperature magnetic resonance data. The method further comprises the step of repeatedly calculating the magnetic susceptibility change map using the fat temperature change map and the fat location data. The method further comprises the step of repeatedly calculating a magnetic field disturbance map using the magnetic susceptibility change map. The method further comprises the step of repeatedly calculating a temperature map using the proton resonant frequency shift magnetic resonance data and the preliminary proton resonant frequency shift magnetic resonance data, and the magnetic field disturbance map. The benefits of this embodiment have been previously discussed.

### BRIEF DESCRIPTION OF THE DRAWINGS

In the following preferred embodiments of the invention will be described, by way of example only, and with reference to the drawings in which:
Fig. 1 shows a flow diagram which illustrates a method according to an embodiment of the invention;
Fig.2 shows a flow diagram which illustrates a method according to a further embodiment of the invention;
Fig. 3 illustrates a medical apparatus according to an embodiment of the invention;
Fig. 4 illustrates a medical apparatus according to a further embodiment of the invention;
Fig. 5 illustrates a medical apparatus according to a further embodiment of the invention; and
Fig. 6 illustrates a medical apparatus according to a further embodiment of the invention.

### DETAILED DESCRIPTION OF THE EMBODIMENTS

Like numbered elements in these figures are either equivalent elements or perform the same function. Elements which have been discussed previously will not necessarily be discussed in later figures if the function is equivalent.

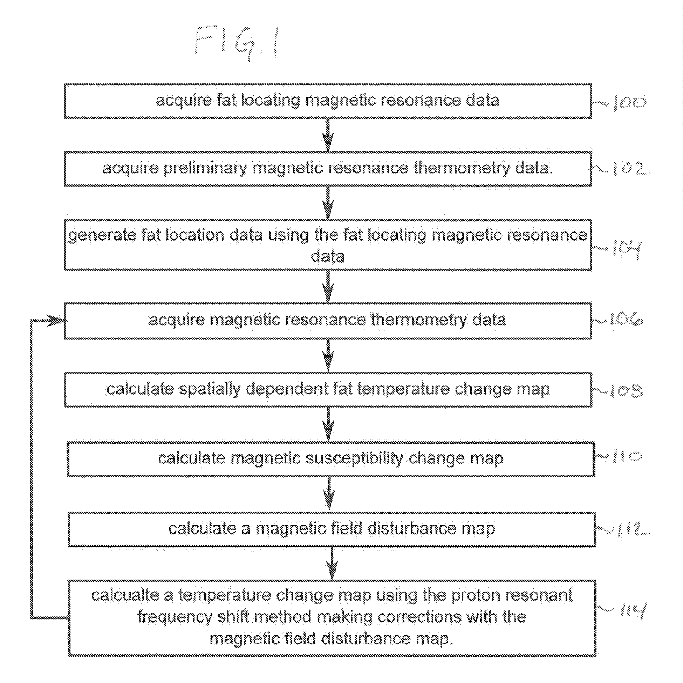

Fig. 1 shows a flow diagram which illustrates a method according to an embodiment of the invention. In step 1 fat locating magnetic resonance data is acquired. Next in step 102 preliminary magnetic resonance thermometry data is acquired. The preliminary magnetic resonance thermometry data comprises preliminary proton resonant frequency shift magnetic resonance data and preliminary fat temperature magnetic resonance data. In step 104 fat location data is generated using the fat locating magnetic resonance data. Next step 106 is performed. In step 106 the magnetic resonance thermometry data is acquired. The magnetic resonance thermometry data comprises proton resonant frequency shift magnetic resonance data and fat temperature magnetic resonance data. Next in step 108 a spatially dependent fat temperature change map is calculated using the preliminary fat temperature magnetic resonance data and the fat temperature magnetic resonance data. Step 110 is performed next. In step 110 a magnetic susceptibility change map is calculated using the spatially dependent fat temperature change map and the fat location data. Next in step 112 a magnetic field disturbance map is calculated using the magnetic susceptibility change map. Then in step 114 a temperature change map is calculated using the proton resonant frequency shift method and this is corrected using the magnetic field disturbance map. The proton resonant frequency shift magnetic resonance data and the preliminary proton resonant frequency shift magnetic resonance data is used to calculate the temperature change map. Steps 106, 108, 110, 112, and 114 may be performed in a loop or repeatedly. The temperature change map may then be updated periodically.

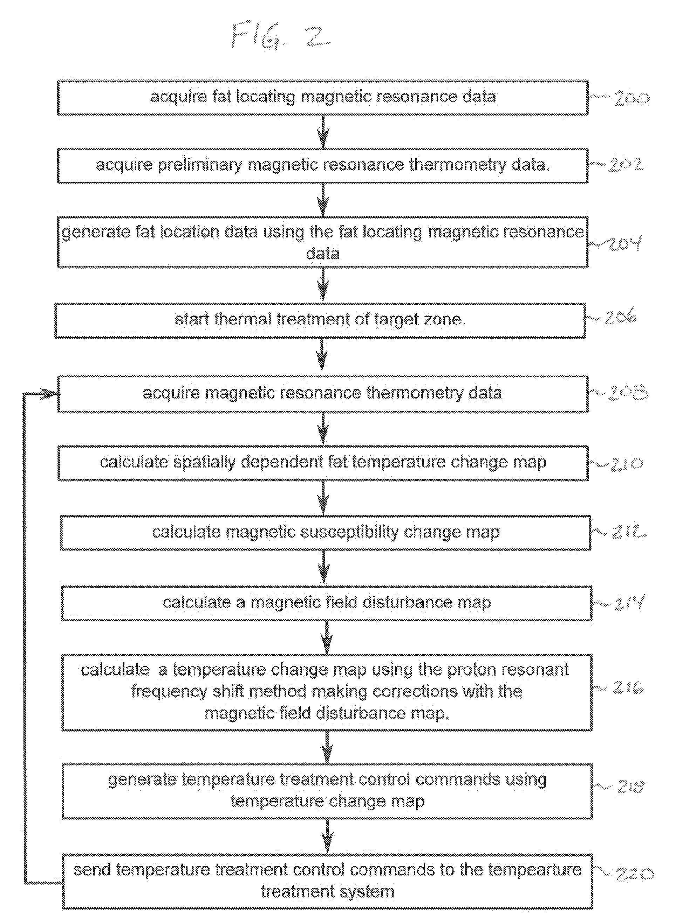

Fig. 2 shows a flow diagram which illustrates a method according to a further embodiment of the invention. The method shown in Fig. 2 is very similar to the method shown in Fig. 1. Step 200 in Fig. 2 corresponds to step 100 in Fig. 1, Step 202 of Fig. 2 corresponds to step 102 of Fig. 1, step 204 corresponds to step 104 of Fig. 1, step 208 corresponds to step 106 of Fig. 1, step 210 corresponds to step 108 of Fig. 1, step 212 corresponds to step 110 of Fig. 1, Step 214 corresponds to step 112 of Fig. 1 and step 220 of Fig. 2 corresponds to step 114 of Fig. 1.

The method shown in Fig. 2 starts with step 200. In step 200 fat locating magnetic resonance data is acquired. In step 202 preliminary magnetic resonance thermometry data is acquired. In step 204 fat location data is generated using the fat locating magnetic resonance data. Next in step 206 thermal treatment of a target zone is started using a thermal treatment system. Essentially the target zone may be treated by the thermal treatment system at least partially during acquisition of the magnetic resonance thermometry data. Next in step 208 magnetic resonance thermometry data is acquired. Next in step 210 spatially dependent fat temperature change map is calculated. In step 212 a magnetic susceptibility change map is calculated. In step 214 a magnetic field disturbance map is calculated. Next in step 216 a temperature change map using the proton resonant frequency shift method is calculated and is corrected using the magnetic field disturbance map to account for changes in the B0 or main magnetic field. Next in step 218 temperature treatment control commands are generated using the temperature change map. The temperature change map is descriptive of a temperature change within the subject. The thermal treatment system is adapted for changing the temperature of the target zone. By examining a temperature change map it can be determined if the thermal treatment system is properly heating or cooling the target zone. The temperature change map can therefore be used to create controls which provide feedback and control the thermal treatment system. Next in step 220 temperature treatment control commands are sent to the temperature treatment system. Steps 208, 210, 212, 214, 216, 218 and 220 form a feedback control loop for controlling the operation of a thermal treatment system by creating the temperature change map.

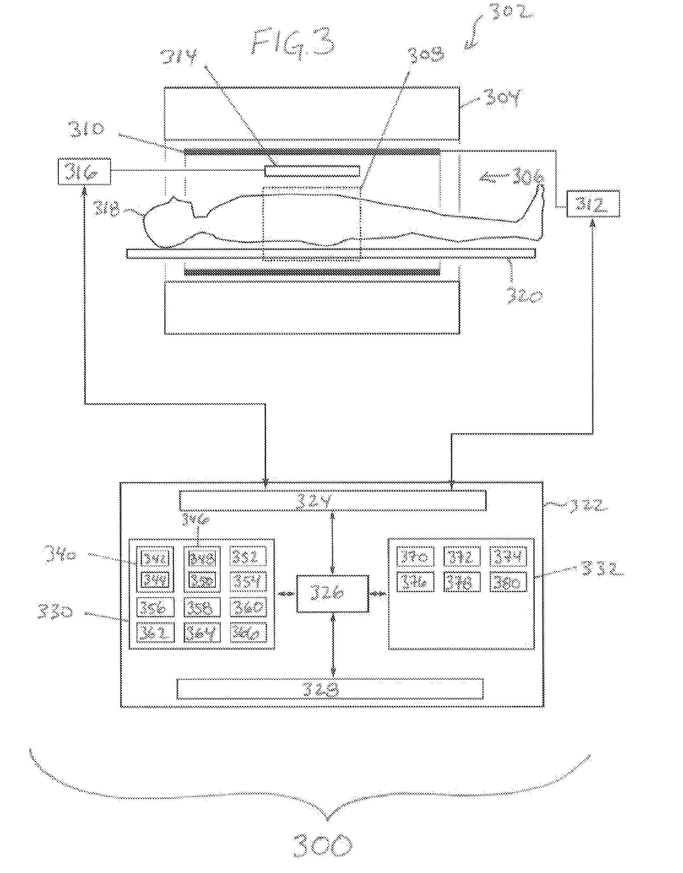

Fig. 3 illustrates a medical apparatus according to an embodiment of the invention. The medical apparatus 300 comprises a magnetic resonance imaging system 302. The magnetic resonance imaging system 302 is shown as comprising a magnet 304. The magnet 304 is a cylindrical type superconducting magnet with a bore 306 through the center of it. The magnet 304 has a liquid helium cooled cryostat with superconducting coils. It is also possible to use permanent or resistive magnets. The use of different types of magnets is also possible for instance it is also possible to use both a split cylindrical magnet and a so called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject: the arrangement of the two sections area similar to that of a Helmholtz coil. Open magnets are popular, because the subject is less confined. Inside the cryostat of the cylindrical magnet there is a collection of superconducting coils. Within the bore of the cylindrical magnet there is an imaging zone 308 where the magnetic field is strong and uniform enough to perform magnetic resonance imaging.

Also within the bore of the magnet is a magnetic field gradient coil 310 which is used for acquisition of magnetic resonance data to spatially encode magnetic spins within an imaging zone of the magnet. The magnetic field gradient coil 310 is connected to a magnetic field gradient coil power supply 312. The magnetic field gradient coil is representative. Typically magnetic field gradient coils contain three separate sets of coils for spatially encoding in three orthogonal spatial directions. A magnetic field gradient power supply 312 supplies current to the magnetic field gradient coils. The current supplied to the magnetic field coils is controlled as a function of time and may be ramped and/or pulsed.

Adjacent the imaging zone 308 is a radio-frequency coil 314. The radio-frequency coil 314 is connected to a radio-frequency transceiver 316. Also within the bore of the magnet 306 is a subject 318 that is reposing on a subject support 320 and is partially within the imaging zone 308.

Adjacent to the imaging zone 308 is a radio-frequency coil 314 for manipulating the orientations of magnetic spins within the imaging zone 308 and for receiving radio transmissions from spins also within the imaging zone 308. The radio-frequency coil 314 may contain multiple coil elements. The radio-frequency coil 314 may also be referred to as a channel or an antenna. The radio-frequency coil is connected to a radio frequency transceiver 316. The radio-frequency coil 314 and radio frequency transceiver 316 may be replaced by separate transmit and receive coils and a separate transmitter and receiver. It is understood that the radio-frequency coil 314 and the radio-frequency transceiver 316 are representative. The radio-frequency coil 314 is intended to also represent a dedicated transmit antenna and a dedicated receive antenna. Likewise the transceiver 316 may also represent a separate transmitter and a separate receiver.

The magnetic field gradient coil power supply 312 and the radio-frequency transceiver 316 are connected to a hardware interface 324 of a computer system 322. The computer system 322 further comprises a processor 326. The processor 326 is connected to the hardware interface 324. The hardware interface 324 enables the processor 326 to send and receive data and commands to the magnetic resonance imaging system 302. The computer system 322 further comprises a user interface 328, computer storage 330 and computer memory 332.

The computer storage 330 is shown as containing preliminary magnetic resonance thermometry data 340. The preliminary magnetic resonance thermometry data 340 is shown as comprising preliminary proton resonant frequency shift magnetic resonance data 342 and preliminary fat temperature magnetic resonance data 344. The preliminary magnetic resonance thermometry data 340 was acquired using the magnetic resonance imaging system 302. The computer storage 330 is further shown as containing magnetic resonance thermometry data 346. The magnetic resonance thermometry data 346 is shown as comprising proton resonant frequency shift magnetic resonance data 348 and fat temperature magnetic resonance data 350. The magnetic resonance thermometry data 346 was acquired using the magnetic resonance imaging system 304.

The computer storage 330 is further shown as containing fat locating magnetic resonance data 352. The computer storage 330 is further shown as containing fat location data 354 which was generated using the fat locating magnetic resonance data 352. The computer storage 330 is further shown as containing a magnetic susceptibility change map 356 that was calculated using the fat location data 354, the preliminary fat temperature magnetic resonance data 344 and the fat temperature magnetic resonance data 350. The computer storage 330 is further shown as containing a magnetic field disturbance map 358 that was calculated using the magnetic susceptibility change map 356. The computer storage 330 is further shown as containing a temperature map 360. The temperature map was calculated using the magnetic field disturbance map 358, the preliminary proton resonant frequency shift magnetic resonance data 342 and the proton resonant frequency shift magnetic resonance data 348.

The computer storage 330 is further shown as containing a fat locating pulse sequence 362. The fat locating pulse sequence is a peak pulse sequence or a set of control commands which enable the magnetic resonance imaging system 302 to acquire the fat locating magnetic resonance data 352. The computer storage 330 is further shown as containing a thermometry pulse sequence 364. The thermometry pulse sequence 364 is a pulse sequence or a set of control and command instructions for the magnetic resonance imaging system 302 which enable it to acquire the preliminary magnetic resonance thermometry data 340 and the magnetic resonance thermometry data 346. The computer storage is further shown as containing a spatially dependent fat temperature change map 366.

The computer memory 332 is shown as containing computer executable code. The computer memory 332 is shown as containing a control module 370. The control module contains computer executable instructions which enable the processor 326 to control the operation and function of the medical apparatus 300. The computer memory 332 is shown as containing an image reconstruction module 372. The image reconstruction module 372 contains computer executable code for constructing a magnetic resonance image using magnetic resonance data. The image reconstruction module 372 may also be used for partially generating the fat location data 354, the spatially dependent fat temperature change map 366 and the temperature map 360. The computer memory 332 is further shown as containing a magnetic susceptibility calculation module 376. The magnetic susceptibility calculation module 376 contains computer executable code which was used to calculate the magnetic susceptibility change map using the fat location data 354 and the spatially dependent fat temperature change map 366.

The computer memory 332 is further shown as containing the magnetic field disturbance calculation module 378. The magnetic field disturbance calculation module 378 contains computer executable code which was used to calculate the magnetic field disturbance map 358 using the magnetic susceptibility change map 356. The computer memory 332 is shown as containing a temperature mapping module 380. The temperature mapping module 380 contains computer executable code which was used to calculate the temperature map 360 using the magnetic field disturbance map 358, the preliminary proton resonant frequency shift magnetic resonance data 342 and the proton resonant frequency shift magnetic resonance data 348. The temperature mapping module 380 may also be used to calculate the spatially dependent fat temperature change map 366 using the preliminary fat temperature magnetic resonance data 344 and the fat temperature magnetic resonance data 350.

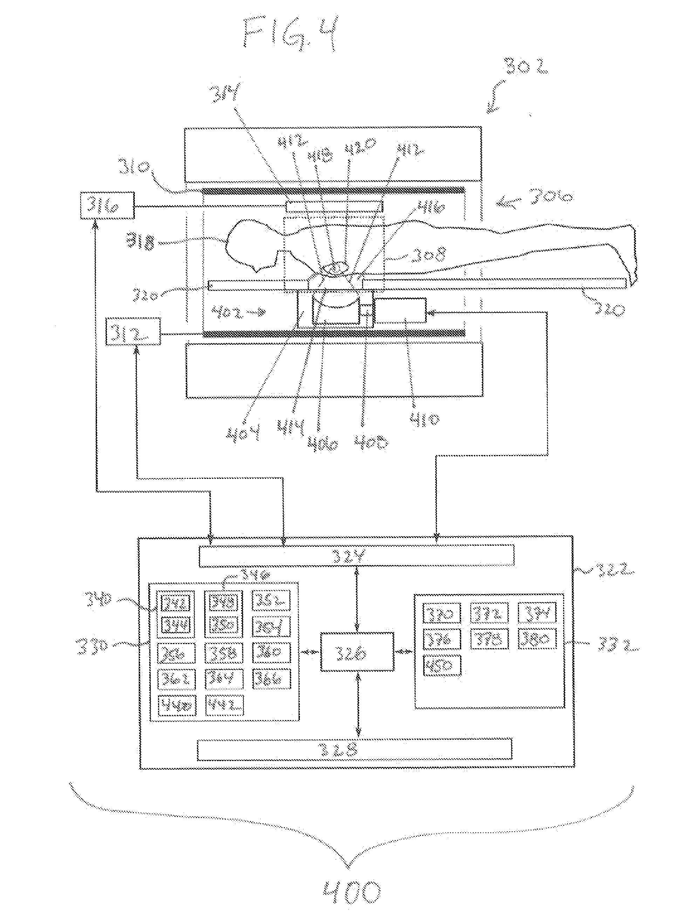

Fig. 4 illustrates a medical apparatus 400 according to a further embodiment of the invention. The embodiment shown in Fig. 4 comprises a temperature treatment system which is a high-intensity focused ultrasound system 402. The high-intensity focused ultrasound system comprises a fluid-filled chamber 404. Within the fluid-filled chamber 404 is an ultrasound transducer 406. Although it is not shown in this Figure. the ultrasound transducer 406 may comprise multiple ultrasound transducer elements each capable of generating an individual beam of ultrasound. This may be used to steer the location of a sonication point 418 electronically by controlling the phase and/or amplitude of alternating electrical current supplied to each of the ultrasound transducer elements.

The ultrasound transducer 406 is connected to a mechanism 408 which allows the ultrasound transducer 406 to be repositioned mechanically. The mechanism 408 is connected to a mechanical actuator 410 which is adapted for actuating the mechanism 408. The mechanical actuator 410 also represents a power supply for supplying electrical power to the ultrasound transducer 406. In some embodiments the power supply may control the phase and/or amplitude of electrical power to individual ultrasound transducer elements. In some embodiments the mechanical actuator/power supply 410 is located outside of the bore 304 of the magnet 302.

The ultrasound transducer 406 generates ultrasound which is shown as following the path 412. The ultrasound 412 goes through the fluid-filled chamber 408 and through an ultrasound window 414. In this embodiment the ultrasound then passes through a gel pad 416. The gel pad is not necessarily present in all embodiments but in this embodiment there is a recess in the subject support 320 for receiving a gel pad 416. The gel pad 416 helps couple ultrasonic power between the transducer 406 and the subject 318. After passing through the gel pad 416 the ultrasound 412 passes through the subject 318 and is focused to a sonication point 418. The sonication point 418 is being focused within a target zone 420. The sonication point 418 may be moved through a combination of mechanically positioning the ultrasonic transducer 406 and electronically steering the position of the sonication point 418 to treat the entire target zone 420. Such a medical apparatus 400 may be used to treat tissues which are at least partially fat. Examples include, but are not limited to: breast tissue, tissue in the pelvic cavity, and tissue in the abdominal cavity.

The high-intensity focused ultrasound system 402 is shown as being also connected to the hardware interference 324 of the computer system 322. The computer system 322 and the contents of its storage 330 and memory 332 are equivalent to that as shown in Fig. 3.

The computer storage 332 is shown as containing a treatment plan 444. The treatment plan 440 may contains a description and/or instructions for treating the target zone 420 by the temperature treatment system 402. The treatment plan 444 may in some embodiments contain anatomical data which allows the processor 344 to register the target zone 420 to magnetic resonance images generated by the magnetic resonance imaging system 301. The computer storage 330 is shown as further containing temperature treatment system control commands 442. The temperature treatment system control commands 442, when sent by the processor 326 to the high-intensity focused ultrasound system 402, causes it to sonicate the sonication zone 418 and also move the sonication point around the target zone 420.

The computer memory 332 is further shown as containing temperature treatment system control command generation module 450. The temperature treatment system control command generation module 450 contains computer executable code which was used to generate the temperature treatment system control command 442 from the treatment plan 440 and the temperature map 360.

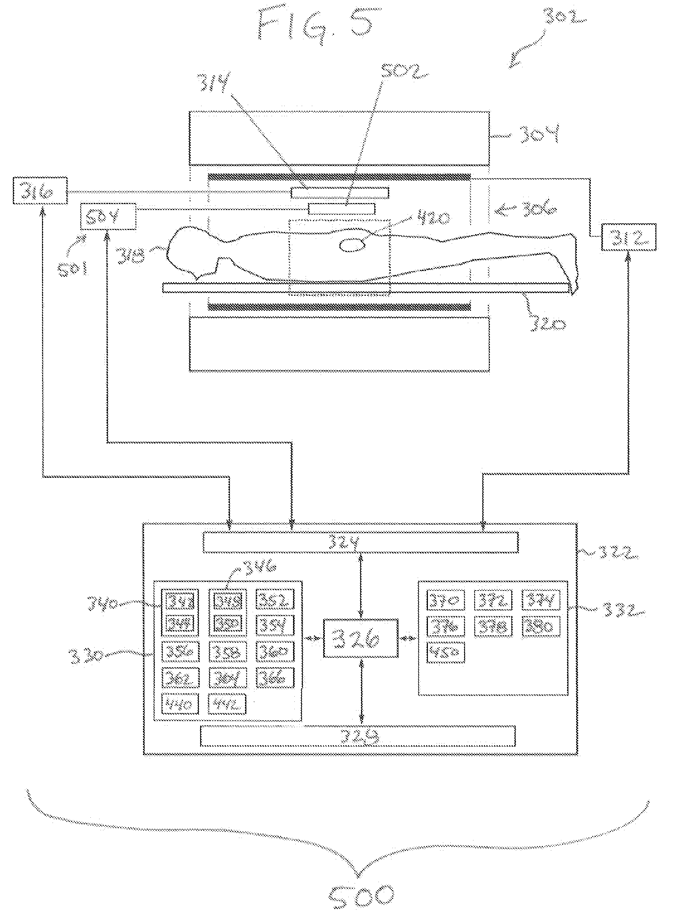

Fig. 5 shows a medical apparatus 500 according to a further embodiment of the invention. The embodiment shown in Fig. 5 is similar to that shown in Figs. 3 and 4. The computer system 322 of Fig. 5 is equivalent to the computer system 322 shown in Figs. 3 and 4 also. The contents of the computer storage 330 and the computer memory 332 are also equivalent to the computer storage 330 and the computer memory 332 as shown in Figs. 3 and 4. In the embodiment shown in Fig. 5 a radio-frequency tissue heating system 501 is used as the temperature treatment system. The radio-frequency temperature treatment system 501 comprises an antenna 502 and a radio-frequency transmitter 504. The antenna 502 is in the vicinity of target zone 420. Radio-frequency energy generated by the transmitter 504 and radiated by the antenna 502 is used to selectively heat the target zone 420. In this embodiment the radio-frequency transmitter 504 is shown as being connected to the hardware interface 324. The processor 326 and the contents of the computer storage 330 and the computer memory 332 are used to control the radio-frequency transmitter 504 in a manner equivalent to the way the high-intensity focused ultrasound system 402 of Fig. 4 is controlled by the processor 324.

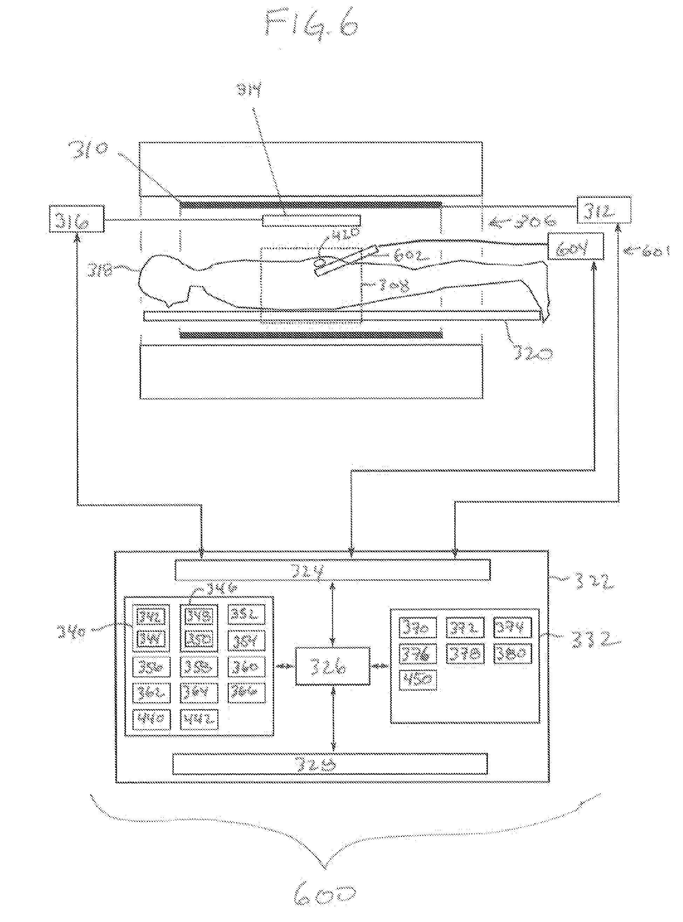

Fig. 6 shows a medical apparatus 600 according to a further embodiment of the invention. In this embodiment a thermal treatment system 601 is shown. There is an applicator 602 which has been inserted into the subject 312. Near the tip of the applicator 602 is the treatment zone 420. The thermal treatment system 602 here is representative and may be either a microwave applicator, a cryo-ablator, or a laser. The applicator 602 may be adapted for supplying microwave energy for delivering a cryogenic substance to the subject 312 or may be adapted for focusing laser light into the target zone 420. Likewise the supply system 604 may be a microwave power supply, a supply system with a cryogenic or cooling fluid, or it may be a laser power supply. The thermal treatment system 601 is shown as being connected to the hardware interface 324 of the computer system 332. The contents of the computer storage 330 and the computer memory 332 are equivalent to the embodiments shown in Figs. 3, 4 and 5. The instructions and computer code contained therein allow the processor 324 to control the thermal treatment system 601 in a manner equivalent to the embodiments shown in Figs. 4 and 5.

The feasibility of the proposed method and apparatus was tested in an oil/water phantom. First, the T1 temperature coefficient of oil was calibrated. Next, a phantom containing a cylinder filled with water with an inner cylinder filled with oil was allowed to cool slowly from about 60 to 35 °C. During cooling, PRFS-based temperature maps of the water and T1 maps of the oil were acquired. The temperature in the water was monitored at two locations with a fiber optic probe. The PRFS MRT maps were corrected using the local phase change caused by the field disturbances, which was calculated by converting T1 changes in oil to field disturbances in water using a Fourier Transform-based field calculation technique.

For location 1, the mean/max abs PRF error was 0.9/1.6 °C uncorrected and 0.3/0.5 °C corrected. For location 2, the mean/max abs PRF error was 1.6/3.2 °C uncorrected and 0.5/1.0 °C corrected.

These tests demonstrated that temperature errors in MR thermometry of water caused by susceptibility changes due to cooling of oil can largely be corrected by simultaneous MR Thermometry of oil and subsequent calculation of field disturbance maps.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

### LIST OF REFERENCE NUMERALS:

- 300: medical apparatus
- 302: magnetic resonance imaging system
- 304: magnet
- 306: bore of magnet
- 308: imaging zone
- 310: magnetic field gradient coil
- 312: magnetic field gradient coil power supply
- 314: radio frequency coil
- 316: radio frequency transceiver
- 318: subject
- 320: subject support
- 322: computer system
- 324: hardware interface
- 326: processor
- 328: user interface
- 330: computer storage
- 332: computer memory
- 340: preliminary magnetic resonance thermometry data
- 342: preliminary proton resonant frequency shift magnetic resonance data
- 344: preliminary fat temperature magnetic resonance data
- 346: magnetic resonance thermometry data
- 348: proton resonant frequency shift magnetic resonance data
- 350: fat temperature magnetic resonance data
- 352: fat locating magnetic resonance data
- 354: fat location data
- 356: magnetic susceptibility change map
- 358: magnetic field disturbance map
- 360: temperature map
- 362: fat locating pulse sequence
- 364: thermometry pulse sequence
- 366: spatially dependent fat temperature change map
- 370: control module
- 372: image reconstruction module
- 374: fat locating module
- 376: magnetic susceptibility calculation module
- 378: magnetic field disturbance calculation module
- 380: temperature mapping module
- 400: medical apparatus
- 402: high intensity focused ultrasound system
- 404: fluid filled chamber
- 406: ultrasound transducer
- 408: mechanism
- 410: mechanical actuator/power supply
- 412: path of ultrasound
- 414: ultrasound window
- 416: gel pad
- 418: sonication point
- 420: target zone
- 440: treatment plan
- 442: temperature treatment system control commands
- 450: temperature treatment system control command generation module
- 500: medical apparatus
- 501: radio-frequency tissue heating system
- 502: antenna
- 504: radio-frequency transmitter
- 600: medical apparatus
- 601: thermal treatment system
- 602: applicator
- 604: supply system

## Claims

1. A medical apparatus (300, 400, 500, 600) comprising:
- a magnetic resonance imaging system (302) for acquiring magnetic resonance data (340, 342, 344, 346, 348, 350, 352) from a subject (318);
- a processor (326) for controlling the medical apparatus; and
- a memory (322) containing machine executable instructions (370, 372, 374, 376, 378, 380) for execution by the processor, wherein execution of the instructions cause the processor to acquire (100, 200) fat locating magnetic resonance data (352) using the magnetic resonance imaging system, wherein execution of the instructions further cause the processor to acquire (102, 202) preliminary magnetic resonance thermometry data (340) using the magnetic resonance imaging system, wherein the preliminary magnetic resonance thermometry data comprises preliminary proton resonant frequency shift magnetic resonance data (342) and preliminary fat temperature magnetic resonance data (344), wherein execution of the instructions further causes the processor to generate (104, 204) fat location data (354) using the fat locating magnetic resonance data, wherein the fat location data is descriptive of the spatial distribution of fat within the subject; wherein execution of the instructions cause the processor to repeatedly:
- acquire (106, 208) magnetic resonance thermometry data (346) using the magnetic resonance imaging system, wherein the magnetic resonance thermometry data comprises proton resonant frequency shift magnetic resonance data (348) and fat temperature magnetic resonance data (350);
- calculate (108, 210) a spatially dependent fat temperature change map (366) using the preliminary fat temperature magnetic resonance data and the fat temperature magnetic resonance data;
- calculate (110, 212) a magnetic susceptibility change map (356) using the fat temperature change map and the fat location data;
- calculate (112, 214) a magnetic field disturbance map (358) using the magnetic susceptibility change map;
- calculate (114, 216) a temperature map (360) using the proton resonant frequency shift magnetic resonance data, the preliminary proton resonant frequency shift magnetic resonance data, and the magnetic field disturbance map.

2. The medical apparatus of claim 1, wherein the medical apparatus further comprises a thermal treatment system (402, 501, 601) for treating a target zone (420) of the subject, wherein execution of the instructions further causes the processor to treat (206) the target zone at least partially during acquisition of the magnetic resonance thermometry data.

3. The medical apparatus of claim 2, wherein execution of the instructions further cause the processor to:
- generate (218) temperature treatment system control commands (442) in accordance with the temperature map; and
- send (220) the temperature treatment system control commands to the temperature treatment system.

4. The medical apparatus of claim 2 or 3, wherein the temperature treatment system is any one of the following: a high intensity focused ultrasound system (402), a radio-frequency tissue treating system (501), microwave applicator (601), a cryo-ablator (601), and a laser (601).

5. The medical apparatus of any one of the preceding claims, wherein the magnetic field disturbance map is calculated numerically using a Fourier transform method.

6. The medical apparatus of any one of the preceding claims, wherein the fat temperature magnetic resonance data is acquired using a fat selective pulse sequence.

7. The medical apparatus of claim 6, wherein the fat temperature magnetic resonance data comprises any one of the following: fat T1 relaxation time data, fat T2 relaxation time data, fat T2-star relaxation time data, and proton density data.

8. The medical apparatus of any one of claim 6, wherein the fat temperature magnetic resonance data comprises fat T1 relaxation time data, wherein the fat selective pulse sequence comprises at least one fat selective binomial radio frequency excitation pulse.

9. The medical apparatus of any one of the preceding claims, wherein the medical apparatus of any one of the preceding claims, wherein the fat location data is a fat mask, wherein the fat mask identifies voxels with fat content above a predetermined threshold.

10. The medical apparatus of any one of claims 1 through 8, wherein the fat location data is descriptive of the fat content of individual voxels.

11. The medical apparatus of any one of the preceding claims, wherein the magnetic resonance thermometry data and/or the preliminary magnetic resonance thermometry data is acquired using any one of the following: interleaving pulse sequences to sequentially acquire the proton resonant frequency shift magnetic resonance data and the fat temperature magnetic resonance data and simultaneously acquiring the proton resonant frequency shift magnetic resonance data and the fat temperature magnetic resonance data.

12. The medical apparatus of any one of the preceding claims, wherein the fat locating magnetic resonance data is magnetic resonance data acquired using a Dixon technique.

13. The medical apparatus of any one of the preceding claims, wherein the temperature map is corrected using the magnetic field disturbance map.

14. A computer program product comprising machine executable instructions (370, 372, 374, 376, 378, 380) for execution by a processor (326) adapted for controlling a medical apparatus (300, 400, 500, 600), wherein the medical apparatus comprises a magnetic resonance imaging system (302) for acquiring magnetic resonance data (340, 342, 346, 348, 350, 352) from a subject (318); wherein execution of the instructions cause the processor to acquire (100, 200) fat locating magnetic resonance data (352) using the magnetic resonance imaging system; wherein execution of the instructions further cause the processor to acquire (102, 2029 preliminary magnetic resonance thermometry data (340) using the magnetic resonance imaging system; wherein the preliminary magnetic resonance thermometry data comprises preliminary proton resonant frequency shift magnetic resonance data (342) and preliminary fat temperature magnetic resonance data (344); wherein execution of the instructions further causes the processor to generate (104, 204) fat location data (354) using the fat locating magnetic resonance data; wherein the fat location data is descriptive of the spatial distribution of fat within the subject; and wherein execution of the instructions cause the processor to repeatedly:
- acquire (106, 208) magnetic resonance thermometry data using the magnetic resonance imaging system, wherein the magnetic resonance thermometry data comprises proton resonant frequency shift magnetic resonance data and fat temperature magnetic resonance data;
- calculate (108, 210) a spatially dependent fat temperature change map using the preliminary fat temperature magnetic resonance data and the fat temperature magnetic resonance data;
- calculate (110, 212) the magnetic susceptibility change map (356) using the fat temperature change map and the fat location data;
- calculate (112, 214) a magnetic field disturbance map (358) using the magnetic susceptibility change map;
- calculate (114, 216) a temperature map (360) using the proton resonant frequency shift magnetic resonance data, the preliminary proton resonant frequency shift magnetic resonance data, and the magnetic field disturbance map.

15. A method of calculating a temperature map (360) using a magnetic resonance imaging system (302) adapted for acquiring magnetic resonance data (340, 342, 346, 348, 350, 352) from a subject (318); wherein the method comprises the step of causing the processor to acquire (100, 200) fat locating magnetic resonance data (352) using the magnetic resonance imaging system; wherein the method further comprises the step of causing the processor to acquire (102, 202) preliminary magnetic resonance thermometry data (340) using the magnetic resonance imaging system; wherein the preliminary magnetic resonance thermometry data comprises preliminary proton resonant frequency shift magnetic resonance data (342) and preliminary fat temperature magnetic resonance data (344); wherein the method further comprises the step of generating (104, 204) fat location data using the fat locating magnetic resonance data; wherein the fat location data is descriptive of the spatial distribution of fat within the subject; and wherein the method further comprises repeatedly performing the steps of:
- acquiring (106, 208)magnetic resonance thermometry data (346) using the magnetic resonance imaging system, wherein the magnetic resonance thermometry data comprises proton resonant frequency shift magnetic resonance data (348) and fat temperature magnetic resonance data (350);
- calculating (108, 210) a spatially dependent fat temperature change map (366) using the preliminary fat temperature magnetic resonance data and the fat temperature magnetic resonance data;
- calculating (110, 212) a magnetic susceptibility change map (356) using the fat temperature change map and the fat location data;
- calculating (112, 214) a magnetic field disturbance map (358) using the magnetic susceptibility change map;
- calculating (114, 216) the temperature map using the proton resonant frequency shift magnetic resonance data, the preliminary proton resonant frequency shift magnetic resonance data, and the magnetic field disturbance map.
